# EUROPÄISCHE PATENTSCHRIFT

(11) **EP 4 260 417 B1**
(45) Veröffentlichungstag und Bekanntmachung des Hinweises auf die Patenterteilung: **28.01.2026**
(21) Anmeldenummer: 21839138.1
(22) Anmeldetag: 14.12.2021
(51) Int. Cl.: H01S 5/024, H01S 5/20, H01S 5/0237, H01S 5/323

(54) **LASERDIODE MIT INTEGRIERTER THERMISCHER BLENDE**
LASER DIODE WITH INTEGRATED THERMAL APERTURE
DIODE LASER À OUVERTURE THERMIQUE INTÉGRÉ

(30) Priorität: 14.12.2020 DE 102020133368
(43) Veröffentlichungstag der Anmeldung: 18.10.2023
(73) Patentinhaber: Ferdinand-Braun-Institut gGmbH, Leibniz-Institut für Höchstfrequenztechnik, 12489 Berlin (DE)
(72) Erfinder: DELLA CASA, Pietro, 12489 Berlin (DE); CRUMP, Paul, 10245 Berlin (DE); ELATTAR, Mohamed, 12489 Berlin (DE); KAROW, Matthias M., 10439 Berlin (DE)
(74) Vertreter: Gulde & Partner
(86) Internationale Anmeldenummer: PCT/EP2021/085730
(87) Internationale Veröffentlichungsnummer: WO 2022/129075

(56) Entgegenhaltungen:
- US-A1- 2001 017 870
- US-B1- 8 233 513
- ELATTAR M ET AL: "High-brightness broad-area diode lasers with enhanced self-aligned lateral structure", SEMICONDUCTOR SCIENCE TECHNOLOGY, IOP PUBLISHING LTD, GB, vol. 35, no. 9, 27 July 2020 (2020-07-27), pages 95011, XP020356115, ISSN: 0268-1242, [retrieved on 20200727], DOI: 10.1088/1361-6641/AB9BEC

## Beschreibung

Die vorliegende Erfindung betrifft eine Laserdiode mit einer integrierten thermischen Blende.

### Stand der Technik

Breitstreifen-Diodenlaser (engl. "broad-area diode lasers", BALs) können eine besonders hohe Effizienz und Brillanz aufweisen. Mit diesen Emittern lassen sich zuverlässig Ausgangsleistungen von >15 W erreicht. BALs sind die effizienteste Lichtquelle für Strahlung im nahen Infrarot (NIR), so dass sie als Pumpquelle für Festkörper- und Faserlaser weit verbreitet sind. Sie sind auch das Schlüsselelement von fasergekoppelten Lasersystemen, die für die Bereitstellung von Strahlen hoher Strahlungsdichte für die Materialbearbeitung bei hohen Wand-Stecker-Effizienzen ausgelegt sind. Um die Ausgangsleistung dieser Systeme zu erhöhen und ihre Kosten zu senken, ist es wichtig, die Strahlqualität der langsamen Achse zu verbessern, da dies die Kopplung einer größeren Anzahl von Emittern in Fasern mit geringer numerischer Apertur (NA) ermöglicht.

Bei hohen optischen Ausgangsleistungen und den damit verbundenen Betriebsströmen kommt es jedoch im Allgemeinen zu einer deutlichen Verschlechterung der Strahlqualität, was sich insbesondere negativ auf eine Kopplung in Fasern auswirkt. Es konnte gezeigt werden, dass die thermische Linse (und nicht die ladungsträger- oder verstärkungsinduzierte Führung) in der langsamen Achse eine der vorherrschenden Ursachen für die Verschlechterung der Strahlqualität bei erhöhtem Betriebsstrom ist (Bai, J. G. et al., Mitigation of Thermal Lensing Effect as a Brightness Limitation of High-Power Broad Area Diode Lasers, Proc. SPIE 7953, 79531F (2011)). Entscheidend für die Verschlechterung der Strahlqualität bei hohen Ausgangsleistungen ist somit die Ausbildung eines lateralen Temperaturgradienten aufgrund einer Temperaturerhöhung im zentralen Bereich unter dem Laserstreifen, welche zu einer lokalen Erhöhung des Brechungsindex und somit zu einer zusätzlichen lateralen Wellenführung und als Folge zu einem größeren Divergenzwinkel führt.

Zur Verbesserung des Wärmetransports wurden insbesondere eine Verlängerung des Laserresonators oder eine Beeinflussung des thermischen Flusses zwischen Laserdiode und Submount (Wärmepfadtechnik; siehe z. B. Bai et al., DE 10 2013 114 226 B4 und US 2016 0315 446 A1) vorgeschlagen. Dadurch kann der laterale Temperaturgradient verringert und somit die erzeugte thermischen Linse abgeflacht werden. Diodenlaser mit längeren Resonatoren haben allerdings höhere Herstellungskosten. Erst kürzlich konnte jedoch gezeigt werden, dass sich an der Grenzfläche zwischen der Laserdiode und einer entsprechenden Metallisierung eine hohe thermische Barriere ausbildet, welche die Wirksamkeit der Wärmepfadtechnik auf der thermische Linse erheblich reduziert (Rieprich, J. et al., Chip-carrier thermal barrier and its impact on lateral thermal lens profile and beam parameter product in high power broad area lasers, J. Appl. Phys. 123, 125703 (2018)).

Eine weitere Möglichkeit zur Verringerung des lateralen Temperaturgradienten ist das zusätzliche Aufheizen der Laserdiode mit einer externen Wärmequelle (Hohimer, J. P., Mode control in broad area diode lasers by thermally induced lateral index tailoring, Appl. Phys. Lett. 52, 260 (1988)). Die Integration einer externen Wärmequelle in einen Diodenlaser ist jedoch sehr aufwendig und daher wenig praktikabel.

Eine Verringerung des lateralen Temperaturgradienten kann auch über eine speziell angepasste Schichtstruktur erreicht werden (Winterfeldt, M. et al., Assessing the Influence of the Vertical Epitaxial Layer Design on the Lateral Beam Quality of High-Power Broad Area Diode Lasers, Proc. SPIE 9733, 97330O (2016)). Durch eine solche Anpassung lässt sich die laterale Strahlqualität jedoch nur geringfügig verbessern. Zudem sind solche Anpassungen nur bei bestimmten Laserdesigns möglich.

US 2001/0017870 A1 betrifft einen Halbleiterlaser mit mehreren transversalen Moden und hoher Leistung, welcher eine große Breite des aktiven oder lichtemittierenden Bereichs aufweist. M. Elattar et al., Semicond. Sci. Technol. 35 (2020) 095011 beschreibt eine Laserdiode mit einer großen Breite des aktiven Bereichs beruhend auf dem GaAs Materialsystem und einer dünnen InGaP Einschnürungsschicht.

US 8,233,513 B1 offenbart einen kantenemittierenden Breitstreifen-Diodenlaser mit verringertem thermischen Kontakt zur Minimierung der Divergenz des Laserstrahls in der langsamen Achse.

### Offenbarung der Erfindung

Es ist daher eine Aufgabe der vorliegenden Erfindung, eine Laserdiode zur Verfügung zu stellen, bei der der laterale Temperaturgradient verringert und die erzeugte thermische Linse abgeflacht werden können. Insbesondere soll die Laserdiode keine externe Wärmequelle oder Anpassungen bei dem chipexternen Schichtaufbau (z. B. bei der Metallisierung) erfordern, d. h. nur auf monolithisch integrierten Strukturen innerhalb der Diodenlaser basierend.

Diese Aufgaben werden erfindungsgemäß durch die Merkmale des Patentanspruches 1 gelöst. Zweckmäßige Ausgestaltungen der Erfindung sind in den jeweiligen Unteransprüchen enthalten.

Eine erfindungsgemäße Laserdiode umfasst eine zwischen einem n-dotierten Halbleitermaterial und einem p-dotierten Halbleitermaterial ausgebildete aktive Schicht, wobei die aktive Schicht entlang einer Längsachse eine aktive Zone mit einer Breite w zur Erzeugung elektromagnetischer Strahlung ausbildet; wobei im p-dotierten Halbleitermaterial eine schichtförmig ausgebildete thermische Blende mit einem Wärmeleitkoeffizient *k*_{block} kleiner als ein Wärmeleitkoeffizient *k*_{bulk} des p-dotierten Halbleitermaterials (beispielsweise im p-dotierten Halbleitermaterial zwischen der aktiven Zone und einer gekühlten Unterseite der Laserdiode) für einen räumlich selektiven Wärmetransport von der aktiven Zone zu einer der aktiven Schicht gegenüberliegenden Seite des p-dotierten Halbleitermaterials ausgebildet ist; oder im n-dotierten Halbleitermaterial eine schichtförmig ausgebildete thermische Blende mit einem Wärmeleitkoeffizient *k*_{block} kleiner als ein Wärmeleitkoeffizient *k*_{bulk} des n-dotierten Halbleitermaterials für einen räumlich selektiven Wärmetransport von der aktiven Zone zu einer der aktiven Schicht gegenüberliegenden Seite des n-dotierten Halbleitermaterials ausgebildet ist, wobei die Laserdiode auf der Basis von GaAs oder AlₓGa₁₋ₓAs und die thermische Blende aus InGaP, InGaAsP, InGaAsSb oder einem InGaP-InGaAsP Superlattice aufgebaut ist, und wobei die thermische Blende eine Blendendicke *d*_{block} zwischen 0,3 µm und 3 µm aufweist.

Eine erfindungsgemäße thermische Blende kann somit sowohl im p-dotierten Halbleitermaterial als auch im n-dotierten Halbleitermaterial ausgebildet sein, wobei vorzugsweise eine Ausbildung innerhalb des entsprechenden Halbleitermaterials erfolgt. Im Folgenden wird beispielhaft von einer p-seitigen thermischen Blende ausgegangen, die Ausführungen gelten jedoch für eine n-seitige thermische Blende entsprechend.

Als Laserdiode wird dabei eine aus einem Halbleitermaterial bestehende Schichtstruktur mit oder ohne Metallisierung verstanden (sog. Laserchip). Der Begriff Halbleitermaterial wird hierbei generisch zur Bezeichnung irgendeines Halbleitermaterials oder einer Kombination von Halbleitermaterialen verwendet, beispielsweise einer Kombination aus dem des AllnGaAsNSb-Materialsystem. Insbesondere können das n-dotierte Halbleitermaterial und das p-dotierten Halbleitermaterial auch jeweils Schichtsysteme aus entsprechenden verschiedenartigen oder unterschiedlich stark dotierten Halbleitermaterialien in verschiedenen Zusammensetzungen umfassen. Die Verwendung ist somit als synonym zu den Begriffen n-seitiges Halbleitermaterial und p-seitiges Halbleitermaterial zu verstehen.

Am Übergangsbereich zwischen dem n-dotierten und dem p-dotierten Halbleitermaterial ist eine aktive Schicht ausgebildet. Die Erzeugung elektromagnetischer Strahlung findet im elektrisch gepumpten Bereich der aktiven Schicht innerhalb der aktiven Zone statt. Dort wird ein Großteil der beim Betrieb der Laserdiode entstehenden Wärme erzeugt, welche entsprechend abgeführt werden muss. Dies kann insbesondere über einen Submount erfolgen, wobei der Submount beispielsweise unterhalb der aktiven Zone mit der Unterseite der Laserdiode thermisch leitfähig verbunden sein kann. Die Verbindung zwischen der Unterseite der Laserdiode und dem Submount gehört dabei zum Stand der Technik und kann insbesondere mittels Löten oder Kleben erfolgen.

Erfindungsgemäß wird im p-dotierten Halbleitermaterial eine schichtförmig ausgebildete thermische Blende mit einem Wärmeleitkoeffizient *k*_{block} kleiner als ein Wärmeleitkoeffizient *k*_{bulk} des umliegenden p-dotierten Halbleitermaterials unterhalb der aktiven Zone für einen räumlich selektiven Wärmetransport von der aktiven Zone zur Unterseite der Laserdiode ausgebildet. Der Wärmeleitkoeffizient (auch als Wärmeleitfähigkeit oder Wärmeleitzahl bezeichnet) bestimmt den Wärmefluss durch ein Material auf Grund der Wärmeleitung. Je geringer dieser Wert ist, desto schlechter sind die Wärmeleiteigenschaften eines Materials. Eine thermische Blende soll erfindungsgemäß die lateralen Temperaturgradienten reduzieren (d. h. die thermische Linse abflachen), indem durch lokale Erhöhung der Wärmewiderstand im herkömmlichen Aufweitungsbereich (seitlich unterhalb der aktiven Zone) in lateraler Richtung einer räumlichen lateralen Aufweitung des Wärmeflusses im Bereich zwischen der aktiven Zone und der Unterseite der Laserdiode entgegengewirkt wird. Infolge ihres erhöhten Wärmewiderstands steigt die lokale Temperatur der Seitenbereiche (der thermischen Blende) an, wenn mit zunehmender Ausgangsleistung innerhalb des Streifens (im Zentralbereich) mehr Wärme erzeugt wird. Dies entspricht einem geringeren Wärmegradienten zwischen dem Zentralbereich und den Seitenbereichen und somit einer flacheren thermischen Linse.

Hinsichtlich des Verhältnisses zwischen den beiden Wärmeleitkoeffizienten kommt es insbesondere auf den Wärmeleitkoeffizienten *k*_{bulk} des p-dotierten Halbleitermaterials unterhalb der aktiven Zone an. Bei einem aus mehreren Schichten aufgebauten p-dotierten Halbleitermaterial können die einzelnen Schichten jeweils leicht unterschiedliche Wärmeleitkoeffizienten *k*_{layer} aufweisen. Der Wärmeleitkoeffizienten *k*_{bulk} kann dann als resultierender Wärmeleitkoeffizienten aller am Wärmefluss beteiligten Schichten angesehen werden. Näherungsweise kann für den Wärmeleitkoeffizient *k*_{bulk} des p-dotierten Halbleitermaterials unterhalb der aktiven Zone auch ein durchschnittlicher Wärmeleitkoeffizient des p-dotierten Halbleitermaterials angesetzt werden. Alternativ kann als eine Näherung der Wärmeleitkoeffizient *k*_{bulk} des p-dotierten Halbleitermaterials auch mit dem Wärmeleitkoeffizient *k*_{KS} einer p-Kontaktschicht des p-dotierten Halbleitermaterials gleichgesetzt werden.

Die Idee der vorliegenden Erfindung liegt somit insbesondere darin, durch die Integration einer monolithisch integrierten thermischen Blende (interne Wärmepfadtechnik) unmittelbar in die Laserdiode eine flache thermische Linse realisiert werden kann. Externe Wärmepfadtechniken sind aufgrund der Präsenz der intrinsische Halbleiter-Metall-Thermobarriere demgegenüber weniger effektiv. Eine erfindungsgemäße thermische Blende kann zudem sehr dicht an die aktive Zone herangebracht werden, so dass die Aufweitung des Wärmeflusses in lateraler Richtung minimiert wird, was zu einer besonders flachen thermischen Linse führt. Die aus dem Stand der Technik bekannte Wärmepfadtechnik kann somit innerhalb der Laserdiode zur Anwendung kommen, wodurch deren Effektivität und Wirksamkeit deutlich erhöht werden kann.

Die thermische Blende besteht aus einem Halbleitermaterial. Dieses sollte eine besonders kleine Wärmeleitfähigkeit (für kleine Wärmeleitkoeffizient *k*_{block}) aufweisen. Zudem ist eine hohe elektrische Leitfähigkeit bevorzugt. Der Wärmeleitkoeffizient *k*_{block} kann durch einen veränderten Indium- und/oder Phosphoranteil herabgesetzt werden (z. B. GaAs und AlGaAs als p-Halbleitermaterial, InGaP oder InGaAsP als thermische Blende). Vorzugsweise ist die thermische Blende zur Erreichung besonders kleiner Wärmeleitkoeffizienten *k*_{block} aus sich periodisch abwechselnde Materialen (beispielsweise unterschiedliche Halbleiter oder Halbleiter und Luft) ausgebildet, mit hohen Anzahl an regelmäßigen Wechseln zwischen der Materialen, wobei viele Grenzflächen mit großen Unterschieden in der Wärmeleitfähigkeit *k*_{layer} ausgebildet werden. Der Wärmetransport über Grenzflächen hinweg ist limitiert und bringt eine zusätzliche Senkung der Wärmeleitfähigkeit *k*_{block} (siehe J. Piprek et al., Thermal conductivity reduction in GaAs-AlAs distributed Bragg reflectors, in IEEE Photon. Tech. Lett. 10, 81(1998)). Vorzugsweise kann die thermische Blende mit einer photonischen Kristallstruktur realisiert werden. Unter einer photonischen Kristallstruktur werden 3-D periodische Nanostrukturen verstanden, welche die Bewegung von Photonen innerhalb des Kristallgitters beeinflussen können. Typischerweise werden zur Erzeugung eines hohen Brechungsindexkontrasts mit Luft oder andere besonders niedrige Brechzahlmaterial gefüllte Öffnungen ("Luftlöcher") in den Strukturen ausgebildet. Diese Öffnungen und die vielfältige Materialübergänge sind für eine besonders hohe Herabsetzung der Wärmeleitfähigkeit in diesen Materialien verantwortlich. Zusammenfassend, mit phonischen Kristallstrukturen lassen sich Bereiche mit guten optischen Eigenschaften und sehr geringer Wärmeleitfähigkeit erzeugen. Ähnliches gilt für 1-D periodische Gitter (Superlattice), bei denen dünne Schichten aus zwei verschiedenen Materialen und insbesondere Halbleitermaterialien abwechselnd aufeinander angeordnet sind.

Mit einer erfindungsgemäßen Laserdiode lassen sich somit trotz einer zusätzlichen thermischen Blende die optischen Eigenschaften des Bereichs unterhalb der aktiven Zone weitgehend erhalten.

Bei Laserdioden auf der Basis von GaAs (*k*_{KS} ≈ 44 W/(m·K)) oder AlₓGa₁₋ₓAs (*k*_{KS} ≈ 11-91 W/(m·K)) wird eine thermische Blende aus InGaP (*k*_{block} ≈ 5 W/(m·K)). InGaAsP (*k*_{block} ≈ 5 W/(m·K)), InGaAsSb oder einem InGaP-InGaAsP Superlattice (*k*_{block} ≈ 2,5 W/(m·K)) aufgebaut.

Für eine ausreichende Blendenwirkung sollte der Wärmeleitkoeffizient *k*_{block} möglichst gering sein. Der Wärmeleitkoeffizient *k*_{block} sollte bevorzugt maximal 30%, bevorzugter maximal 10%, bevorzugter maximal 5% und besonders bevorzugt maximal 1% des entsprechenden Bulk-Wertes *k*_{bulk} betragen. Mit einem InGaP-InGaAsP Superlattice lässt sich ein Wärmeleitkoeffizient *k*_{block} erreichen, welcher etwa bei der Hälfte der Werte für den Wärmeleitkoeffizient *k* von InGaP und InGaAsP liegt (siehe J. Piprek et al., Thermal conductivity reduction in GaAs-AlAs distributed Bragg reflectors, in IEEE Photon. Tech. Lett. 10, 81 (1998)). Durch photonische Kristallstrukturen lassen sich jedoch auch deutlich geringere Wärmeleitfähigkeiten realisieren.

Vorzugsweise bildet die thermische Blende einen parallel zur aktiven Schicht angeordneten spaltförmigen Durchlassbereich für einen von der aktiven Zone in Richtung einer Außenseite (z. B. einer mit einem Kühlkörper versehenen p-seitigen Unterseite bei einer p-seitigen thermischen Blende) der Laserdiode gerichteten Wärmefluss aus. Bei einer solchen Anordnung kann die thermische Blende den Wärmefluss entlang der gesamten Resonatorachse (z-Achse) auf einen spaltförmigen Durchlass beschränken. Eine zentralsymmetrische Anordnung des spaltförmigen Durchlassbereichs bezüglich der aktiven Zone (mediale Anordnung) ist dabei aus Effizienzgründen bevorzugt.

Vorzugsweise gilt für den lateralen Abstand *dx* zwischen einem Außenrand der aktiven Zone (seitliche Begrenzung in lateraler Richtung) und einem nächstgelegenen Innenrand der thermischen Blende (zur aktiven Zone gerichtete seitliche Begrenzung in lateraler Richtung) *-w*/6 ≤ *dx ≤ +w*/6. Dies bedeutet, dass der Abstand bevorzugt von der Breite w der aktiven Zone abhängt und derart gewählt ist, dass der Innenrand der thermische Blende sowohl einen positiven als auch einen negativen lateralen Abstand zum Außenrand der aktiven Zone aufweisen kann. Besonderes bevorzugt ist ein Abstand *dx* von 0, d. h. wenn der Außenrand der aktiven Zone und der entsprechende Innenrand der thermischen Blende bei einer Projektion auf Unterseite der Laserdiode räumlich zusammenfallen.

Vorzugsweise gilt für den vertikalen Abstand *dy* zwischen der Mitte der aktiven Schicht und der Oberseite der thermischen Blende 0 µm ≤ *dy* ≤ 1 µm. Dies bedeutet, dass die Oberseite der thermischen Blende bevorzugt unmittelbar unterhalb der Mitte der aktiven Schicht und maximal 1 µm davon entfernt angeordnet ist. Ein möglichst geringer Abstand hat die höchste Blendenwirkung, kann sich jedoch negativ auf die optischen Eigenschaften auswirken. Bei einem Abstand von größer als 1 µm kann die laterale Aufweitung des Wärmeflusses eventuell nicht mehr effektiv unterdrückt werden.

Die thermische Blende weist eine Blendendicke *d*_{block} zwischen 0,3 µm und 3 µm auf. Eine dickere thermische Blende kann dabei eine stärkere Unterdrückung der lateralen Aufweitung des Wärmeflusses bewirken.

Vorzugsweise weist das p-dotierte Halbleitermaterial (mit integrierter thermischer Blende) eine Gesamtschichtdicke *d* zwischen 0,5 µm und 10 µm auf, bevorzugter zwischen 1 µm und 5 µm, noch bevorzugter zwischen 2 µm und 3 µm.

Vorzugsweise sind eine schichtförmig ausgebildete thermische Blende im n-dotierten Halbleitermaterial und eine schichtförmig ausgebildete thermische Blende im p-dotierten Halbleitermaterial ausgebildet. Die thermische Blende im n-dotierten Halbleitermaterial kann funktional der thermischen Blende im p-dotierten Halbleitermaterial entsprechen. Insofern gelten alle zur thermische Blende im p-dotierten Halbleitermaterial in dieser Beschreibung gemachten Angaben unter Berücksichtigung des Wechsels bei der Dotierung entsprechend. Bevorzugt können die thermische Blende im n-dotierten Halbleitermaterial und die thermische Blende im p-dotierten Halbleitermaterial symmetrisch in Bezug auf die aktive Schicht aufgebaut sein. Diese Symmetrie kann sich insbesondere auf die geometrische und/oder materielle Ausbildung der thermischen Blenden beziehen. Die Ausbildung der thermischen Blenden kann sich jedoch auch unterscheiden, etwa wenn das p-dotierten Halbleitermaterial und das n-dotierte Halbleitermaterial unterschiedliche Dicken aufweisen und eine Anpassung der Abstände erforderlich ist. Eine solche Ausführungsform ist vorteilhaft, wenn die Laserdiode zur doppelseitigen Kühlung montiert ist, d. h. wenn eine Wärmeextraktion zu beiden Seiten der Laserdiode erfolgen kann.

Weitere bevorzugte Ausgestaltungen der Erfindung ergeben sich aus den in den Unteransprüchen genannten Merkmalen.

Die verschiedenen in dieser Anmeldung genannten Ausführungsformen der Erfindung sind, sofern im Einzelfall nicht anders ausgeführt, mit Vorteil miteinander kombinierbar solange die daraus resultierenden Merkmalskombinationen noch unter den beanspruchten Gegenstand fallen.

### Kurzbeschreibung der Zeichnungen

Die Erfindung wird nachfolgend in Ausführungsbeispielen anhand der zugehörigen Zeichnung erläutert. Es zeigen:
- Fig. 1: eine schematische Darstellung einer exemplarischen herkömmlichen Laserdiode ohne thermische Blende,
- Fig. 2: eine schematische Darstellung einer exemplarischen ersten Ausführungsform einer erfindungsgemäßen Laserdiode mit thermischer Blende,
- Fig. 3: eine Simulation der Temperatur als Funktion der lateralen Position (x-Achse) innerhalb der aktiven Zone,
- Fig. 4: eine Simulation des normierten thermischen Linsenkrümmungsfaktor |B2| als Funktion des Wärmeleitkoeffizienten *k*_{KS} der p-Kontaktschicht,
- Fig. 5: eine Simulation des normierten thermischen Linsenkrümmungsfaktor |B2| als Funktion der Blendedicke *d*_{block},
- Fig. 6: eine Simulation des normierten thermischen Linsenkrümmungsfaktor |B2| als Funktion des lateralen Abstands *dx*,
- Fig. 7: eine Simulation der Temperaturdifferenz ΔT zwischen der Temperatur T als Funktion der lateralen Position (x-Achse) und der Spitzentemperatur Tₚₑₐₖ an der Position x = 0 für Strukturen mit dem KS-Material nach Fig. 4, und
- Fig. 8: eine schematische Darstellung einer exemplarischen zweiten Ausführungsform einer erfindungsgemäßen Laserdiode mit zwei thermischen Blenden.

### Ausführliche Beschreibung der Zeichnungen

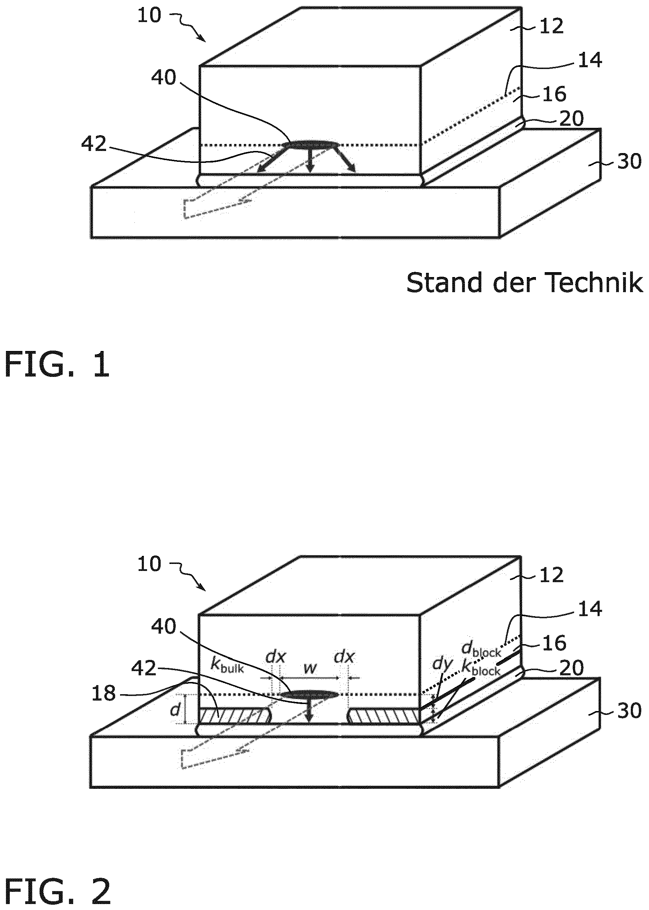

Figur 1 zeigt eine schematische Darstellung einer exemplarischen herkömmlichen Laserdiode ohne thermische Blende. Der gezeigte Diodenlaser umfasst eine Laserdiode 10 mit einer zwischen einem n-dotierten Halbleitermaterial 12 und einem p-dotierten Halbleitermaterial 16 ausgebildeten aktiven Schicht 14, wobei die aktive Schicht 14 entlang einer Längsachse eine aktive Zone 40 mit einer Breite *w* zur Erzeugung elektromagnetischer Strahlung ausbildet; und einen Submount 30, wobei der Submount 30 unterhalb der aktiven Zone 40 mit der p-seitigen Unterseite der Laserdiode 10 thermisch leitfähig verbunden ist. Die thermische leitfähige Verbindung kann dabei durch eine zwischenliegende Lotschicht 20 ausgebildet werden, wobei das Lot einen optimalen Wärmeübergang zwischen Unterseite der Laserdiode 10 und dem Submount 30 ermöglichen soll.

Die Laserdiode 10 kann insbesondere einen mehrschichtigen Aufbau mit einem n-Substrat, einer auf dem n-Substrat aufliegenden n-Mantelschicht, einer auf der n-Mantelschicht aufliegenden n-Wellenleiterschicht, einer auf der n-Wellenleiterschicht aufliegenden aktive Schicht 14, einer auf der aktiven Schicht 14 aufliegenden p-Wellenleiterschicht, einer auf der p-Wellenleiterschicht aufliegenden p-Mantelschicht, einer auf der p-Mantelschicht aufliegenden p-Kontaktschicht, und einem auf der p-Kontaktschicht aufliegenden metallischen p-Kontakt aufweisen.

Die während des Betriebs der Laserdiode in der aktiven Zone 40 als Wärme auftretenden Verluste müssen aus der aktiven Zone 40 abgeführt werden. Dazu wird zumeist ein Submount 30 als entsprechende Wärmesenke (z. B. als Kühlkörper) genutzt. Der dabei von der aktiven Zone 40 auf den Submount 30 gerichtete Wärmefluss breitet sich jedoch in lateraler Richtung stark aus und führt zu einer inhomogenen Temperaturverteilung im Bereich unterhalb der aktiven Zone 40. Die sich einstellende Temperaturverteilung kann dann thermo-optische Effekte auf die erzeugte elektromagnetische Strahlung einwirken und durch die Ausbildung einer thermischen Linse in diesem Bereich zu einer Verschlechterung der Strahlqualität bei der Strahlungsemission beitragen.

Figur 2 zeigt eine schematische Darstellung einer exemplarischen ersten Ausführungsform einer erfindungsgemäßen Laserdiode mit thermischer Blende. Der gezeigte Diodenlaser umfasst ein Laserdiode 10 mit einer zwischen einem n-dotierten Halbleitermaterial 12 und einem p-dotierten Halbleitermaterial 16 ausgebildeten aktiven Schicht 14, wobei die aktive Schicht 14 entlang einer Längsachse (longitudinale Richtung, z-Achse) eine aktive Zone 40 mit einer Breite *w* zur Erzeugung elektromagnetischer Strahlung ausbildet; und einen Submount 30, wobei der Submount 30 unterhalb der aktiven Zone 40 mit der p-seitigen Unterseite der Laserdiode 10 thermisch leitfähig verbunden ist. Dies entspricht soweit dem zu FIG. 1 beschriebenen Aufbau.

Im p-dotierten Halbleitermaterial 16 ist jedoch zusätzlich eine schichtförmig ausgebildete thermische Blende 18 mit einem Wärmeleitkoeffizient *k*_{block} kleiner als ein Wärmeleitkoeffizient *k*_{bulk} des p-dotierten Halbleitermaterials 16 (unterhalb der aktiven Zone 40) für einen räumlich selektiven Wärmetransport von der aktiven Zone 40 zur der der aktiven Schicht 14 gegenüberliegenden Seite des p-dotierten Halbleitermaterials 16 (Unterseite der Laserdiode 10) und somit zum Submount 30 ausgebildet. Näherungsweise kann für den Wärmeleitkoeffizient *k*_{bulk} des p-dotierten Halbleitermaterials unterhalb der aktiven Zone 40 auch ein mittlerer Wärmeleitkoeffizient des p-dotierten Halbleitermaterials 16 angesetzt werden. Alternativ kann näherungsweise der Wärmeleitkoeffizient *k*_{bulk} des p-dotierten Halbleitermaterials 16 auch mit dem Wärmeleitkoeffizient *k*_{KS} einer p-Kontaktschicht des p-dotierten Halbleitermaterials 16 gleichgesetzt werden.

Die thermische leitfähige Verbindung kann auch hierbei durch eine zwischenliegende Lotschicht 20 ausgebildet werden, wobei das Lot einen optimalen Wärmeübergang zwischen Unterseite der Laserdiode 10 und dem Submount 30 ermöglichen soll. Die Verbindung kann auch durch Kleben, z. B. mittels eines Wärmeleitklebers, erfolgen.

Die thermische Blende 18 bildet einen parallel zur aktiven Schicht 14 angeordneten spaltförmigen Durchlassbereich für einen von der aktiven Zone 40 in Richtung der Unterseite der Laserdiode 10 gerichteten Wärmefluss 42 aus. Der spaltförmige Durchlassbereich ist in der Abbildung medial unterhalb der aktiven Zone 40 angeordnet. Eine Ausbreitung des von der aktiven Zone 40 auf den Submount 30 gerichteten Wärmeflusses 42 in lateraler Richtung wird durch die erfindungsgemäße thermische Blende 18 unterdrückt, so dass sich einen weitgehend paralleler Wärmefluss 42 einstellt. Der hohe Wärmewiderstand der thermischen Blende 18 führt zu einer Erhöhung ihrer lokalen Temperatur (d. h. Erwärmung in den Seitenbereichen), wenn mit zunehmender Ausgangsleistung mehr Wärme von der aktiven Zone 40 erzeugt wird. Dies führt zu einer gleichmäßigeren Temperaturverteilung im Bereich unterhalb der aktiven Zone 40 zwischen dem Zentralbereich (direkt unter der aktiven Zone) und der thermische Blende (den Seitenbereichen). Die Ausbildung einer thermischen Linse in diesem Bereich wird somit ebenfalls unterdrückt, wodurch die Strahlqualität bei der Strahlungsemission gesteigert werden kann.

Die Darstellung zeigt weiterhin den horizontalen Abstand *dx* zwischen einem Außenrand der aktiven Zone 40 und einem nächstgelegenen Innenrand der thermischen Blende. Weiterhin gezeigt ist der vertikale Abstand *dy* zwischen der Mitte der aktiven Schicht 14 und der thermischen Blende 18. Ebenfalls in die Darstellung eingezeichnet sind die Blendendicke *d*_{block} der thermische Blende 18 sowie die Gesamtschichtdicke d des p-dotierte Halbleitermaterials 16.

Die Beschreibung gilt entsprechend auch für eine im n-dotierten Halbleitermaterial 12 ausgebildeten thermischen Blende 18. In diesem Fall könnte zur Unterdrückung einer lateralen Aufweitung eines nach oben gerichteten Wärmeflusses 42 ein entsprechender Submount 30 oberhalb der aktiven Zone 40 mit der n-seitigen Oberseite der Laserdiode 10 thermisch leitfähig verbunden sein.

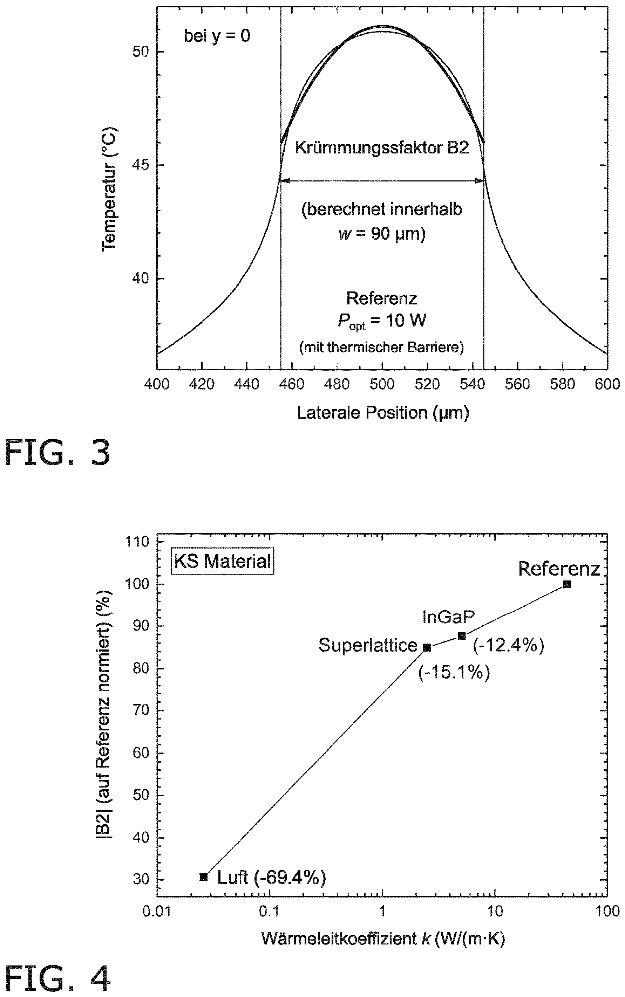

Figur 3 zeigt eine Simulation der Temperatur als Funktion der lateralen Position (x-Achse) innerhalb der aktiven Zone. Die Simulation erfolgte bei einer vertikalen Position (y-Achse) von y = 0, d. h. in der Mitte der aktiven Schicht, für einem GaAs-basierten Breitstreifen-Diodenlaser (BAL) mit einer Streifenbreite w = 90 µm (siehe M. Elattar et al., High-brightness broad-area diode lasers with enhanced self-aligned lateral structure, Semicond. Sci. Technol. 35, 095011 (2020)), der bei einer optischen Leistung Pₒₚₜ = 10 W arbeitet. Der simulierte BAL entspricht dem typischen Aufbau bestehend aus einer aktiven Zone (AZ) zwischen einem n-dotierten und einem p-dotierten Halbleitermaterial. Das p-dotierte Halbleitermaterial besteht aus einer AlₓGa₁₋ₓAs-Wellenleiterschicht (WL), die auf der AZ aufgewachsen ist, gefolgt von einer AlₓGa₁₋ₓAs-Mantelschicht (MS) und schließlich einer GaAs-Kontaktschicht (KS), auf der anschließend ein Kontaktmetall abgeschieden wird. Die Simulation (passend mit entsprechenden experimentellen Ergebnissen) beinhaltet eine Wärmebarriere an der KS-Metall-Grenzfläche. Als thermischer Linsenkrümmungsfaktor B2 wird der quadratische Term einer quadratischen Anpassung des erhaltenen thermischen Profils bezeichnet (Rieprich, J. et al., Chip-carrier thermal barrier and its impact on lateral thermal lens profile and beam parameter product in high power broad area lasers, J. Appl. Phys. 123, 125703 (2018)), wobei in der Simulation eine quadratische Anpassung für den Bereich innerhalb der Streifenbreite w = 90 µm erfolgte. Die exemplarische herkömmliche Diodenlaser in der Simulation zeigt, dass sich ein thermisches Profil mit einem gekrümmten Verlauf zwischen etwa 45 °C an den Rändern und etwa 51 °C in der Mitte des Breitstreifens einstellt.

Figur 4 zeigt eine Simulation des normierten thermischen Linsenkrümmungsfaktor |B2| als Funktion des Wärmeleitkoeffizienten *k*_{KS} der p-Kontaktschicht. In der Referenzstruktur besteht die KS aus GaAs (*k*_{KS} ≈ 44 W/(m·K)). Wenn GaAs durch Materialien mit geringerer Wärmeleitfähigkeit, wie InGaP (*k*_{block} ≈ 5 W/(m·K)), InGaAsP (*k*_{block} ≈ 5 W/(m·K)), ein InGaP-InGaAsP-Superlattice (*k*_{block} ≈ 2,5 W/(m·K); vgl. J. Piprek et al., Thermal conductivity reduction in GaAs-AlAs distributed Bragg reflectors, in IEEE Photon. Tech. Lett. 10, 81(1998)), oder Luft (*k*ₐᵢᵣ ≈ 0,026 W/(m·K) ersetzt wird, wird der normierte thermische Linsenkrümmungsfaktor |B2| reduziert, was einer abgeschwächten thermischen Linse entspricht. Dies führt zu einem kleineren Fernfeldwinkel und damit zu einer verbesserten Strahlqualität. Insbesondere ergab die Simulation, dass eine Reduzierung des normierten thermischen Linsenkrümmungsfaktor |B2| um 5% durch einen verringerten Wärmeleitkoeffizienten *k*_{KS} ≈ 18 W/(m·K) erreicht werden kann. Eine Reduzierung um 10% kann mit einem Wärmeleitkoeffizient *k*_{KS} ≈ 7 W/(m·K) erreicht werden. Für eine Reduzierung um 15% sollte der Wärmeleitkoeffizient *k*_{KS} ≈ 2,5 W/(m·K) betragen.

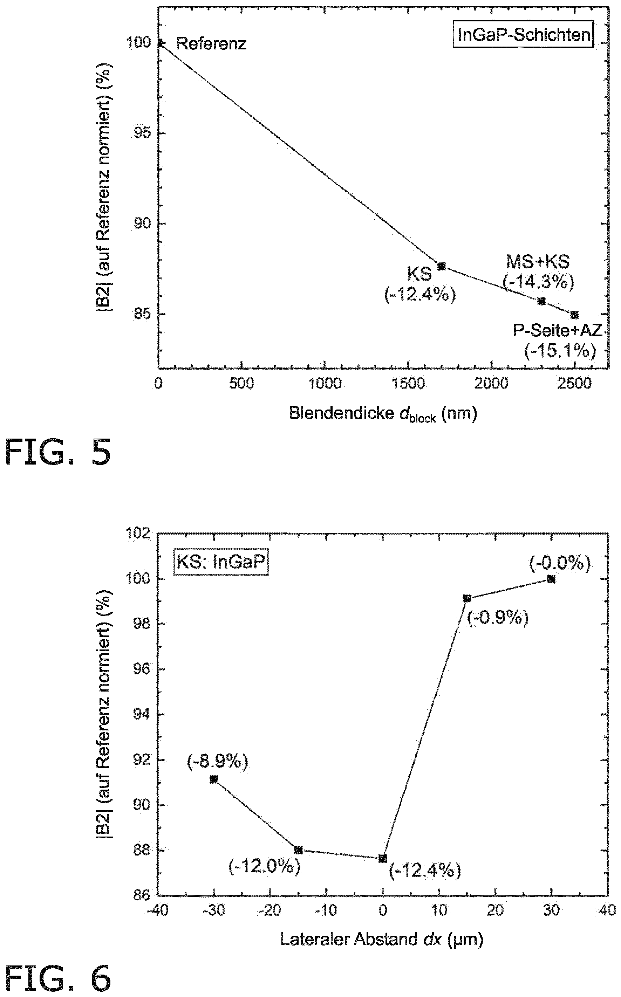

Figur 5 zeigt eine Simulation des normierten thermischen Linsenkrümmungsfaktor |B2| als Funktion der Blendendicke *d*_{block}. Wenn Schichten aus GaAs (KS) oder AlₓGa₁₋ₓAs (MS, WL) durch InGaP (geringer Wärmeleitkoeffizient k) ersetzt werden, wird der normierte thermischen Linsenkrümmungsfaktor |B2| reduziert, was der Ausbildung einer abgeschwächten thermischen Linse entspricht. Dies führt zu einem kleineren Fernfeldwinkel und damit zu einer verbesserten Strahlqualität. Insbesondere ergab die Simulation, dass eine Reduzierung des normierten thermischen Linsenkrümmungsfaktor |B2| um 5% mit einer Blendendicke *d*_{block} ≈ 688 nm erreicht werden kann. Eine Reduzierung um 10% kann mit einer Blendendicke *d*_{block} ≈ 1375 nm erreicht werden.

Figur 6 zeigt eine Simulation des normierten thermischen Linsenkrümmungsfaktor |B2| als Funktion des lateralen Abstands *dx*. Die KS wurde hierbei als aus InGaP bestehend angenommen. Es ist zu beobachten, dass die thermischen Blenden den thermischen Linsenkrümmungsfaktor |B2| am effektivsten reduzieren können, wenn *dx* = 0 ist, d. h. sich der thermisch besonders leitfähige spaltförmige Durchlassbereich unterhalb der aktiven Zone sich perfekt medial mit dem Laserstreifen ausrichtet.

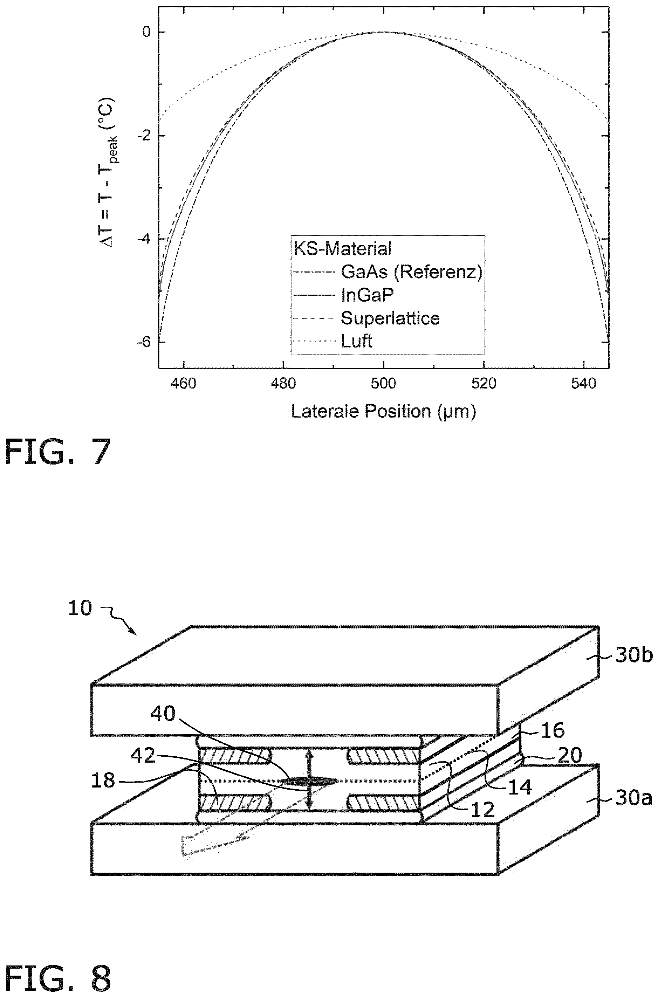

Figur 7 zeigt eine Simulation der Temperaturdifferenz Δ*T* zwischen der Temperatur *T* als Funktion der lateralen Position (x-Achse) und der Spitzentemperatur *T*ₚₑₐₖ an der Position x = 0 für Strukturen mit dem KS-Material nach Fig. 4. Der Kurvenverlauf zeigt die Verringerung der Krümmung der Wärmelinse, wenn GaAs durch Materialien mit geringerer Wärmeleitfähigkeit ersetzt wird.

Figur 8 zeigt eine schematische Darstellung einer exemplarischen zweiten Ausführungsform einer erfindungsgemäßen Laserdiode mit zwei thermischen Blenden. Die gezeigte Laserdiode 10 entspricht vom prinzipiellen Aufbau her im Wesentlichen einer in Fig. 2 gezeigten ersten Ausführungsform einer erfindungsgemäßen Laserdiode 10 mit einer thermischen Blende 18. Die einzelnen Bezugszeichen und deren jeweilige Zuordnung zu den einzelnen Merkmalen gelten daher entsprechend. Im Unterscheid zur Darstellung in Fig. 2 ist hierbei jedoch ein Aufbau mit erfindungsgemäßen thermischen Blenden 18 sowohl im p-dotierten Halbleitermaterial 16 unterhalb der aktiven Schicht 14 als auch im n-dotierten Halbleitermaterial 12 oberhalb der aktiven Schicht 14 dargestellt. Ein erster Submount 30a ist unterhalb der aktiven Zone 40 mit einer Unterseite der Laserdiode 10 thermisch leitfähig verbunden. Weiterhin ist ein zweiter Submount 30b oberhalb der aktiven Zone 40 mit einer Oberseite der Laserdiode 10 thermisch leitfähig verbunden. Eine Kühlung kann somit zu beiden Seiten der Laserdiode 10 erfolgen, wobei eine laterale Aufweitung des Wärmeflusses 42 sowohl zur Oberseite als auch zur Unterseite der Laserdiode 10 durch thermischen Blenden 18 effektiv unterdrückt werden kann. Eine solche Ausführungsform ist vorteilhaft, wenn die Laserdiode 10 zur doppelseitigen Kühlung montiert ist, d. h. wenn eine Wärmeextraktion zu beiden Seiten der Laserdiode 10 erfolgen kann. Die gezeigte Laserdiode ist symmetrisch in Bezug auf die aktive Schicht 14 aufgebaut.

### Bezugszeichenliste

- 10: Laserdiode
- 12: n-dotiertes Halbleitermaterial
- 14: aktive Schicht
- 16: p-dotiertes Halbleitermaterial
- 18: thermische Blende
- 20: Lotschicht
- 30: Submount
- 30a: erster Submount
- 30b: zweiter Submount
- 40: aktive Zone
- 42: Wärmefluss

- *dx*: lateral Abstand (langsame Achse)
- *dy*: vertikaler Abstand (schnelle Achse)
- *d*_{block}: Blendendicke
- w: Breite

## Patentansprüche

1. Laserdiode (10), umfassend:
eine zwischen einem n-dotierten Halbleitermaterial (12) und einem p-dotierten Halbleitermaterial (16) ausgebildete aktive Schicht (14), wobei die aktive Schicht (14) entlang einer Längsachse eine aktive Zone (40) mit einer Breite w zur Erzeugung elektromagnetischer Strahlung ausbildet;
wobei im n- oder p-dotierten Halbleitermaterial (12, 16) eine schichtförmig ausgebildete thermische Blende (18) mit einem Wärmeleitkoeffizient *k*_{block} kleiner als ein Wärmeleitkoeffizient *k*_{bulk} des entsprechend dotierten Halbleitermaterials (12, 16) für einen räumlich selektiven Wärmetransport von der aktiven Zone (40) zu einer der aktiven Schicht (14) gegenüberliegenden Seite des entsprechend dotierten Halbleitermaterials (12, 16) ausgebildet ist;
wobei die Laserdiode (10) auf der Basis von GaAs oder AlₓGa₁₋ₓAs und die thermische Blende aus InGaP, InGaAsP, InGaAsSb oder einem InGaP-InGaAsP Superlattice aufgebaut ist; und
die thermische Blende (18) eine Blendendicke *d*_{block} zwischen 0,3 µm und 3 µm aufweist.

2. Laserdiode (10) nach Anspruch 1, wobei die thermische Blende (18) aus sich periodisch abwechselnde Materialen ausgebildet ist.

3. Laserdiode (10) nach einem der vorhergehenden Ansprüche, wobei die thermische Blende (18) als photonische Kristallstruktur ausgebildet ist.

4. Laserdiode (10) nach einem der vorhergehenden Ansprüche, wobei die thermische Blende (18) elektrisch leitfähig ist.

5. Laserdiode (10) nach einem der vorhergehenden Ansprüche, wobei die thermische Blende (18) einen parallel zur aktiven Schicht (14) angeordneten spaltförmigen Durchlassbereich für einen von der aktiven Zone (40) in Richtung einer Außenseite der Laserdiode (10) gerichteten Wärmefluss (42) ausbildet.

6. Laserdiode (10) nach Anspruch 5, wobei der spaltförmige Durchlassbereich medial bezüglich der aktiven Zone (40) angeordnet ist.

7. Laserdiode (10) nach einem der vorhergehenden Ansprüche, wobei das n- oder p-dotierte Halbleitermaterial mit thermischer Blende (18) eine Gesamtschichtdicke *d* zwischen 0,5 µm und 10 µm aufweist.

8. Laserdiode (10) nach einem der vorhergehenden Ansprüche, wobei für den lateralen Abstand *dx* zwischen einem Außenrand der aktiven Zone (40) und einem nächstgelegenen Innenrand der thermischen Blende (18) -*w*/6 ≤ *dx* ≤ +*w*/6 gilt.

9. Laserdiode (10) nach einem der vorhergehenden Ansprüche, wobei für den vertikalen Abstand *dy* zwischen der Mitte der aktiven Schicht (14) und der Oberseite der thermischen Blende (18) 0 µm ≤ *dy* ≤ 1 µm gilt.

10. Laserdiode (10) nach einem der vorhergehenden Ansprüche, wobei der Wärmeleitkoeffizient *k*_{block} maximal 30% des entsprechenden Wärmeleitkoeffizienten *k*_{bulk} beträgt.

11. Laserdiode (10) nach einem der vorhergehenden Ansprüche, wobei eine schichtförmig ausgebildete thermische Blende (18) im n-dotierten Halbleitermaterial (12) und eine schichtförmig ausgebildete thermische Blende (18) im p-dotierten Halbleitermaterial (16) ausgebildet sind.

## Claims

1. A laser diode (10), comprising:
an active layer (14) formed between an n-doped semiconductor material (12) and a p-doped semiconductor material (16), wherein the active layer (14) forms an active zone (40) with a width *w* along a longitudinal axis for generating electromagnetic radiation;
wherein in the n- or p-doped semiconductor material (12, 16), a layered thermal aperture (18) with a thermal conductivity coefficient *k*_{block} smaller than a thermal conductivity coefficient *k*_{bulk} of the correspondingly doped semiconductor material (12, 16) is formed for spatially selective heat transport from the active zone (40) to a side of the correspondingly doped semiconductor material (12, 16) opposite to the active layer (14);
wherein the laser diode (10) is based on GaAs or AlₓGa₁₋ₓAs, and the thermal aperture is made of InGaP, InGaAsP, InGaAsSb, or an InGaP-InGaAsP superlattice; and
the thermal aperture (18) has an aperture thickness *d*_{block} between 0.3 µm and 3 µm.

2. The laser diode (10) according to claim 1, wherein the thermal aperture (18) is formed from periodically alternating materials.

3. The laser diode (10) according to any one of the preceding claims, wherein the thermal aperture (18) is formed as a photonic crystal structure.

4. The laser diode (10) according to any one of the preceding claims, wherein the thermal aperture (18) is electrically conductive.

5. The laser diode (10) according to any one of the preceding claims, wherein the thermal aperture (18) forms a slit-shaped passage region arranged parallel to the active layer (14) for a heat flow (42) directed from the active zone (40) towards an outer side of the laser diode (10).

6. The laser diode (10) according to claim 5, wherein the slit-shaped passage region is arranged medially with respect to the active zone (40).

7. The laser diode (10) according to any one of the preceding claims, wherein the n- or p-doped semiconductor material with the thermal aperture (18) has a total layer thickness *d* between 0.5 µm and 10 µm.

8. The laser diode (10) according to any one of the preceding claims, wherein a lateral distance *dx* between an outer edge of the active zone (40) and a nearest inner edge of the thermal aperture (18) is *-w*/6 ≤ *dx* ≤ *+w*/*6.*

9. The laser diode (10) according to any one of the preceding claims, wherein a vertical distance *dy* between a center of the active layer (14) and a top of the thermal aperture (18) is 0 µm ≤ *dy* ≤ 1 µm.

10. The laser diode (10) according to any one of the preceding claims, wherein the thermal conductivity coefficient *k*_{block} is at most 30% of the corresponding thermal conductivity coefficient k_{bulk}.

11. The laser diode (10) according to any one of the preceding claims, wherein the layered thermal aperture (18) is formed both in the n-doped semiconductor material (12) and in the p-doped semiconductor material (16).

## Revendications

1. Diode laser (10) comprenant :
une couche active (14) formée entre un matériau semi-conducteur dopé n (12) et un matériau semi-conducteur dopé p (16), la couche active (14) constituant, le long d'un axe longitudinal, une zone active (40) d'une largeur *w* pour générer un rayonnement électromagnétique ;
dans laquelle une ouverture thermique (18) en forme de couche est réalisée dans le matériau semi-conducteur dopé n ou dopé p (12, 16), ladite ouverture thermique présentant un coefficient de conductivité thermique *k*_{block} inférieur au coefficient de conductivité thermique *k*_{bulk} du matériau semi-conducteur correspondant (12, 16), afin d'assurer un transport thermique spatialement sélectif depuis la zone active (40) vers le côté opposé de la couche active (14) du matériau semi-conducteur correspondant (12, 16) ;
dans laquelle la diode laser (10) est réalisée sur la base de GaAs ou AlₓGa₁₋ₓAs et l'ouverture thermique est constituée d'InGaP, d'InGaAsP, d'InGaAsSb ou d'un super-réseau InGaP-InGaAsP ; et
l'ouverture thermique (18) présente une épaisseur *d*_{block} comprise entre 0,3 µm et 3 µm.

2. Diode laser (10) selon la revendication 1, dans laquelle l'ouverture thermique (18) est constituée de matériaux disposés de manière périodiquement alternée.

3. Diode laser (10) selon l'une quelconque des revendications précédentes, dans laquelle l'ouverture thermique (18) est formée en tant que structure cristalline photonique.

4. Diode laser (10) selon l'une quelconque des revendications précédentes, dans laquelle l'ouverture thermique (18) est électriquement conductrice.

5. Diode laser (10) selon l'une quelconque des revendications précédentes, dans laquelle l'ouverture thermique (18) forme une zone de passage en fente disposée parallèlement à la couche active (14), permettant un flux thermique (42) dirigé depuis la zone active (40) vers l'extérieur de la diode laser (10).

6. Diode laser (10) selon la revendication 5, dans laquelle la zone de passage en fente est disposée au milieu de la zone active (40).

7. Diode laser (10) selon l'une quelconque des revendications précédentes, dans laquelle le matériau semi-conducteur dopé n ou p avec ouverture thermique (18) présente une épaisseur totale d comprise entre 0,5 µm et 10 µm.

8. Diode laser (10) selon l'une quelconque des revendications précédentes, dans laquelle la distance latérale dx entre un bord externe de la zone active (40) et le bord interne le plus proche de l'ouverture thermique (18) satisfait la relation *-w*/*6* ≤ *dx* ≤ *+ w*/6*.*

9. Diode laser (10) selon l'une quelconque des revendications précédentes, dans laquelle la distance verticale dy entre le centre de la couche active (14) et la surface supérieure de l'ouverture thermique (18) satisfait la relation 0 µm ≤ *dy* ≤ 1 µm.

10. Diode laser (10) selon l'une quelconque des revendications précédentes, dans laquelle le coefficient de conductivité thermique *k*_{block} est au maximum égal à 30 % du coefficient de conductivité thermique *k*_{bulk} correspondant.

11. Diode laser (10) selon l'une quelconque des revendications précédentes, dans laquelle une ouverture thermique (18) en couche est formée dans le matériau semi-conducteur dopé n (12) et une ouverture thermique (18) en couche est formée dans le matériau semi-conducteur dopé p (16).
